# EUROPEAN PATENT SPECIFICATION

(11) **EP 0 448 273 B1**
(45) Date of publication and mention of the grant of the patent: **28.09.1994**
(21) Application number: 91302072.3
(22) Date of filing: 12.03.1991
(51) Int. Cl.: H01L 23/544, G01R 31/26, H01L 21/66

(54) **Integrated circuit electromigration monitor**
Elektromigrationsüberwachungseinrichtung für integrierte Schaltungen
Dispositif de surveillance d'électromigration pour circuits intégrés

(30) Priority: 21.03.1990 US 497467
(43) Date of publication of application: 25.09.1991
(73) Proprietor: AT&T Corp., New York, NY 10013-2412 (US)
(72) Inventor: Chesire, Daniel Patrick, Slatington, Pennsylvania 18080 (US); Oates, Anthony Stephen, Bethlehem, Pennsylvania 18018 (US)
(74) Representative: Johnston, Kenneth Graham

(56) References cited:
- EP-A- 0 253 746
- WO-A-88/02182
- US-E- 32 625
- Proc. of the Int. Reliability Physics Symp. vol. 23, 1985, New York, pp. 100-107 ; B.J. ROOT et al.: "Wafer Level Electromigration Tests for Production Monitoring".
- Solid-State Electronics vol. 29, no. 9, September 1986, Exeter, Devon, GB, pp. 893-901; H.-U.SCHREIBER: "Bulk Electromigration Reliability Tests of Large-Grained Aluminium Lines with regard to Semiconductor Contacts"
- JOURNAL OF PHYSICS D. APPLIED PHYSICS, vol. 18, no. 2, February 1985, Letchforth, GB, pp. L9-L13; B.R.SETHI et al.: "Characterisation ofelectromigration damage in current-stressed Al gates as used for GaAs MESFET"
- IEEE TRANSACTIONS ON ELECTRON DEVICES, vol. ED-34, no. 3, March 1987, New York, US, pp. 673-681; H.A.SCHAFFT et al.: "Reproducibility of Electromigration Measurements".

## Description

### Background of the Invention

### 1. Field of the Invention

The present invention relates to an improved test structure and method of determining the electromigration characteristics of integrated circuits.

### 2. Description of the Prior Art

The high reliability of integrated circuits is a very significant factor in their production and use. Attempts are made to ensure high reliability in all stages of the production process. Where feasible, tests are performed at intermediate stages of production so that corrective action can be taken if necessary. The importance of this procedure can be understood when it is realized that modem IC production requires hundreds of steps in very carefully controlled environmental conditions. The completion of all the steps for a given wafer typically requires several weeks, or even months, before the final IC wafer is available for electrical testing of its circuits. Therefore, a large inventory of very valuable product is undergoing processing at any given time. If a problem develops at a process step, it may, under worst-case conditions, be several weeks before it is discovered, thereby resulting in a significant economic loss of wafers in process.

One area of traditional concern is the electromigration characteristics of metal (e.g., aluminum, aluminum alloys, and/or refractory metal) conductors in the integrated circuit. Because of the very small linewidths required for present-day IC's, the current density in these conductors, including runners and contacts, is very high, often exceeding 1 X 10⁵ A/cm² in normal device operation. Therefore, if the metal is inadvertently thinner (or narrower) in some portions of the runner than in others, the current density will be even higher than the intended value at those locations. Since the failure rate due to electromigration problems increases rapidly as the current density increases, such unintended thinning of the runners may lead to unacceptable reliability of the IC. Still other factors may affect the electromigration characteristics, such as the presence of impurities or precipitates in the metal that forms the runners, the grain size of the metal, and various other geometry limiting effects.

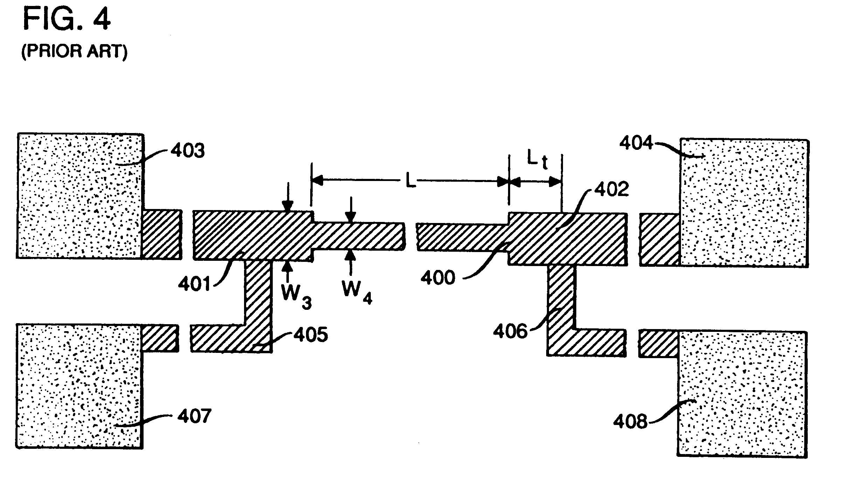

The traditional means for determining the electromigration characteristics, and hence reliability, of the runners is to pass a current through a test structure on an IC wafer, and determine the time it takes for the test structure to fail. The failure may occur, for example, by the test conductor becoming non-conductive, or by one test conductor shorting out to another test conductor. A traditional test structure adopted by the National Bureau of Standards is shown in Fig. 4. A long, thin metal test conductor (400) is connected to broader metal conductors (401, 402) at either end, which connect to bondpads (403, 404) for supplying current from an external power supply. The length L of the test conductor is 800 micrometers, and the width of the broader metal conductors (W₃ ) is twice that of the test conductor (W₄). Voltage monitor test points are provided by conductors 405, 406, spaced Lₜ = 2 X W₃ from the ends of regions 401, 402, and connected to bondpads (407, 408). It is also known in the art to include side conductors (not shown) to determine by means of a short-circuit test whether metal migration occurs transversely to the test conductor.

The current density in the long-term test is typically about 1 to 3 X 10⁶A/cm². In addition, the long-term test provides for the wafer to be heated to approximately 200° to 300°C in order to accelerate the test as much as possible. However, even under these conditions the traditional long- term test requires typically a week or more of operation without a failure to prove that the electromigration characteristics are satisfactory.

A more recent electromigration test technique is termed "SWEAT" (Standard Wafer-level Electromigration Acceleration Test), which provides for passing a much larger current than used for the "long-term" test through a test structure that is optimized for the accelerated test. The large current provides for joule heating of the test conductor only, which avoids the necessity for hearing the entire wafer. The time required for the SWEAT test is typically only about 30 seconds at a current density of about 1 to 2 X 10⁷A/cm² for an aluminum runner. Therefore, SWEAT could potentially be used for monitoring wafer lots in real time, in the sense that the information gained is sufficiently timely that the process parameters can be changed before the next lot arrives at a given process stage. If desired, testing can even be accomplished on each wafer, with appropriate process changes being accomplished before the next wafer. The SWEAT technique is described in "Wafer Level Electromigration Tests for Production Monitoring", B. J. Root et al, in the Proceedings of the International Reliability Physics Symposium, pp. 100-107 (1985).

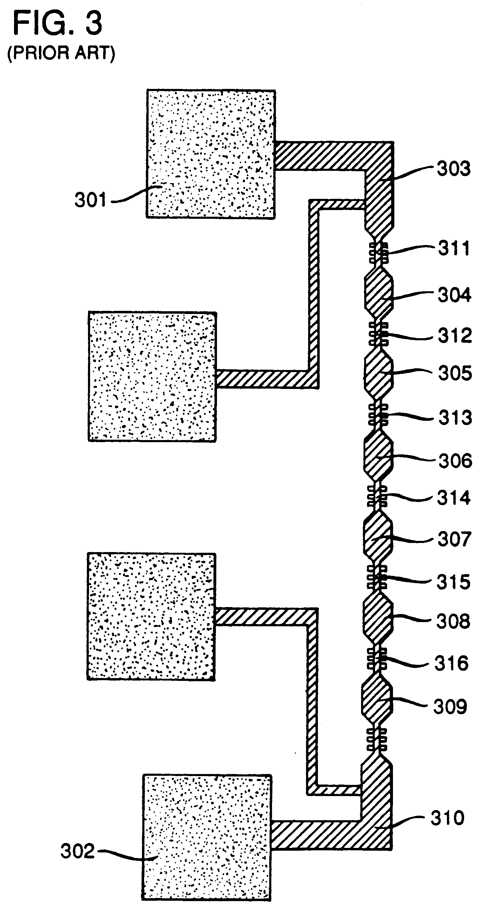

The test structure used for the SWEAT test is shown in Fig. 3. The current is conducted from bondpads 301, 302 into the test structure through relatively wide end conductors 303 and 310. A plurality of relatively wide interior regions (304 ... 309) alternate with relatively narrow regions (311 ... 316). The width of the narrow regions is typically the same as the narrowest linewidth of the metal runners of the integrated circuits on the same wafer as the test structure. The alternation of the wide regions with narrow regions provides for abrupt thermal stress gradients that are thought necessary for the accelerated test. However, the SWEAT test has not been widely adopted in the semiconductor industry. This appear to be due to a lack of correlation between the results produced by SWEAT and the results produced by the more traditional long-term tests. Therefore, there is a need for an accelerated test technique that more accurately simulates the traditional long-term test, and hence give greater confidence as to its ability to accurately predict electromigration characteristics in actual device operation.

### Summary of the Invention

We have invented an improved technique of fabricating an integrated circuit including the step of determining the electromigration characteristics of integrated circuit conductors as set out in claims 1 and 13.

The invention comprises further an integrated circuit including an electromigration test structure as set out in claim 17.

### Brief Description of the Drawing

Fig. 1 shows an illustrative embodiment of the present invention.

Fig. 2 shows a detail of the structure of Fig. 1

Fig. 3 shows a prior art test structure for implementing the SWEAT test.

Fig. 4 shows a prior art test structure for implementing the long-term test.

### Detailed Description

The present detailed description relates to an improved method of rapidly performing an electromigration test. The results obtained may be used to change process conditions in an integrated circuit production line. The present invention includes the use of a test structure that produces results that more closely correlate with long-term test results than those produced by the standard SWEAT structure (Fig. 3).

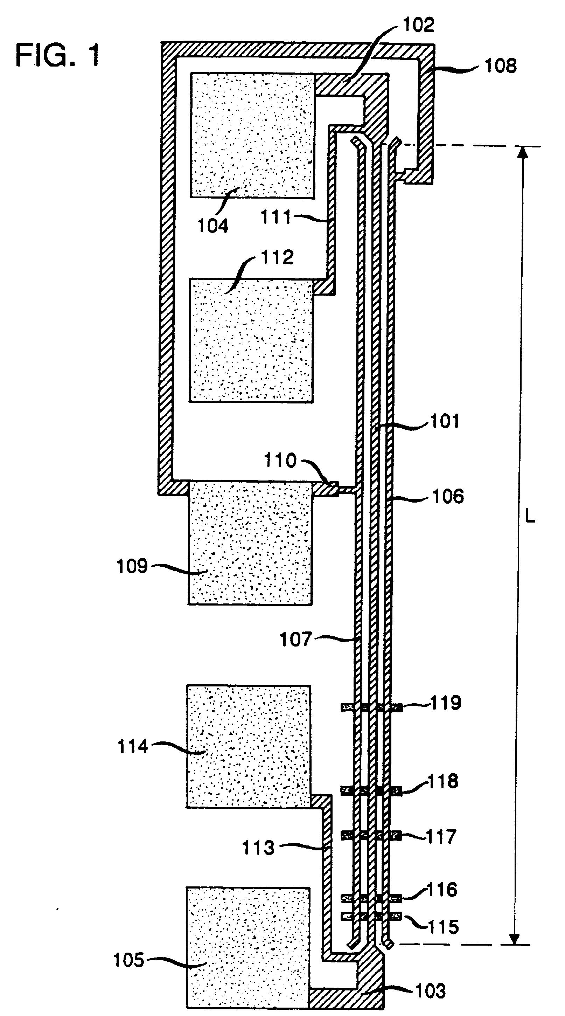

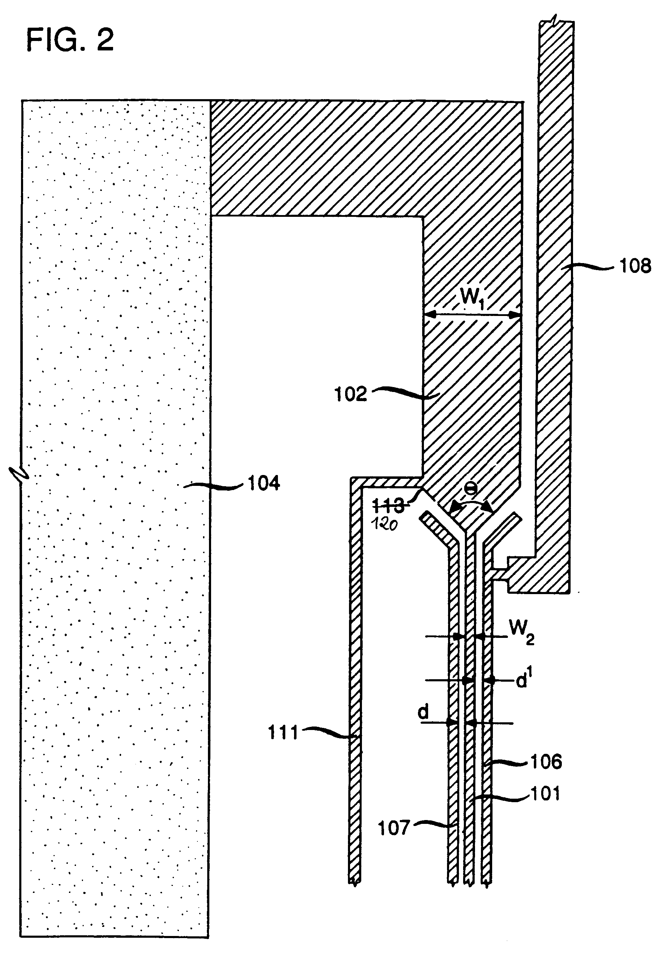

Referring to Fig. 1, an exemplary embodiment of the test structure used with the present technique is shown as formed on an integrated circuit wafer; a detail view of an end region is shown in Fig. 2. The test structure includes an elongated test conductor 101 that is contacted at both ends by broader end conductor 102 and 103, which conduct current from bond pads 104, 105 into the test conductor. The bond pads allow for electrical contact by test probes that conduct current from a source of current external to the integrated circuit wafer on which the test structure is formed. During a test according to one embodiment of the present technique, a current of at least 5 X 10⁶amps/cm², and typically greater than 1 X 10⁷amps/cm² is flowed through test conductor 101, and the time for failure determined. The failure typically occurs within minutes or seconds for these current densities, respectively. A "failure" is typically considered to occur when the test conductor 101 opens (becomes non-conductive), or shorts to an adjacent conductor, but other definitions are possible. For example, when the resistance of conductor 101 exceeds a given value (e.g., twice the initial resistance), a failure may be said to have occurred. This latter definition has the advantage that the current may be terminated before the metal test conductor opens or explodes, thereby reducing the contamination of the integrated circuit by metal debris.

The voltage drop along the test conductor may be measured from bondpads 112 and 114, which connect to the broader end conductors 102 and 103 via conductors 111 and 113, respectively. On either side of the test conductor 101 are optional side conductors 106 and 107, which connect to bondpad 109 via conductors 108 and 110. These optional side conductor, which are similar to those known in the prior art, allow for measurements of short circuits between the side conductors and the test conductor 101 that may occur due to the electromigration of metal from the test conductor. Such short circuits are considered another failure mechanism, and may be determined by measuring the resistance between bondpads 109 and 104, or else between bondpads 109 and 105. The optional side conductors 106 and 107 also serve to emulate minimum-spaced adjacent lines found in operational portions of the IC, and which might affect the patterning and definition of the test conductor.

We have determined that the length L of the test conductor should be at least 50 micrometers, to obtain valid test results. This relatively long length provides for a uniform and relatively gradual thermal gradient. In contrast, the SWEAT structure (Fig. 3) produces non-uniform, sharply-peaked thermal gradients, wherein bulk diffusion may produce the predominant electromigration effect. Surprisingly to workers in the art, the long, gradual thermal gradient, which reduces bulk diffusion effects, provides for test results that better correlate to long-term test results. We hypothesize that the long test conductor length of the inventive technique provides for the "electron wind" to be the predominant effect in determining electromigration. That is, the flow of negative electronic charge due to the test current tends to drag the metal atoms of the test conductor along with it. However, other explanations of the improved results of the present technique are possible. The width W₂ of the test conductor is typically equal to the minimum design width of the metal runners used on a given level of the integrated circuit. In commercial practice, this is less than 10 »m, and typically less that 5 »m.

As an option, topography features may be included underneath the test conductor which run generally transversely to the test conductor. These features, which are otherwise known in the art (Fig. 3), are typically conductor formed in a lower level than the test conductor, and separated therefrom by a dielectric layer. For example, runners 115 ... 119 may be formed of a polysilicon (or silicide) gate conductor layer, or alternatively from a lower metal conductor level. The topography may also be stacked to produce extreme steps over which the test conductor must pass. These runners may be insulated from the test conductor by a deposited silicon dioxide (or doped glass) layer. The topography features are typically variably spaced, as shown. They provide information as to the worst-case failure conditions. That is, when the test conductor fails near a given topography feature, that location may be inspected to determine the quality of the metal coverage over that feature. Typically, thinning of the metal, or a change in the width of the metal, may be found due to step coverage problems, or lithography problems, associated with the given topography feature. (However, failure near a feature may not necessarily result solely from step coverage degradation).

It is often desirable to include two test structures on a given integrated circuit, for comparison purposes. That is, a first test structure can have topographic features located thereunder, whereas a second test structure is located on a planar dielectric surface. Differential measurements between the two test structures may then accurately determine parameters that are affected by the underlying topographical features. Such parameters may include resistance, resistance versus temperature, power versus temperature, and time to fail. A direct comparison is therefore possible that determines the geometry and thermal effects of a runner in a real circuit situation over topography versus an ideal planar test structure. For example, the relatively high sensitivity of differential measurements allows the determination of the incremental resistance change of the conductor over topography. This is especially useful in cases where a determination has been made that when the resistance ratio exceeds a specified value, the lifetime of the product is shortened. Therefore, a resistance ratio versus conductor lifetime pass/fail criterion may be used to control the processing conditions of the production line. The test currents may be flowed sequentially, or alternatively simultaneously through the two test structures. The differential measurements may likewise be performed either sequentially, or alternatively simultaneously. If desired, the currents may be flowed through both in a bridge circuit, where the two structures are arms of a four arm bridge.

Referring to Fig. 2, further details of the test structure are shown. The length L is typically about 800 »m, for providing results that may be most conveniently correlated with those of the traditional long-term test structure. The width W₁, of the broader end conductors is at least 5 times, and typically about 10 times, the width of the test conductor, W₂. This dimensional ratio provides for minimal voltage drop, and minimal electromigration, in the end regions. In addition, a tapered region between each of the colder end regions and the test conductor provides for a controlled thermal gradient, thereby minimizing thermal stress in the test conductor. A taper angle ϑ is defined by the sides of the tapered region as it narrows from the broader end regions into the test conductor region (101). This angle is in the range of 30 to 60 degrees, and desirably about 45 degrees. The tapered region also provides for supplying the current while minimizing current crowding effects. In addition, note that the voltage test conductor (111) connects to the broader end conductor at the point (120) where the taper begins. This provides improved accuracy as compared to prior art techniques, which locate the voltage test conductor further away from the tapered region.

The information gained from the inventive test may be used to adjust processing conditions, as noted above. Typical process steps that may be affected include the dielectric deposition step for the dielectric on which the test conductor is formed. More commonly, the conductor-forming process itself is found to be closely correlated to the failure, and hence in need of adjustment. The thickness of the conductor, its linewidth (determined, for example, by lithography and/or etching processes), and its composition may all be adjusted. For example, when the conductor is aluminum, it may contain small amounts of silicon or copper, which amount may need to be increased or decreased. Similarly, the amount of gaseous constituents (e.g., nitrogen) used in the conductor deposition process may need to be altered, or a contaminant may be discovered and subsequently removed. If the conductor is a stacked metal conductor, for example aluminum on Ti, or TiW, still other conditions may be changed.

The above-noted processing changes may be accomplished on the wafer lot (about 25 to 50 wafers in a typical case) in which only a single wafer is tested. Alternatively, each wafer may be tested, and process adjustments made accordingly, due to the rapid nature of the test. In either case, the information gained by the inventive technique is likely to be of benefit to the entire production process, and all the IC chips therein. That is, the present invention enhances both the yield of integrated circuits, and also the reliability of the IC's. Hence, an economic advantage is gained for every integrated circuit produced, even if it is from a wafer that is not itself tested

Although the inventive test structure has been described above in terms of its advantages for a rapid test at high current densities, it may alternately be used in a more traditional long-term type of test at lower current densities. In that case, the advantages include reduced electromigration failures due to the taper that connect the broader metal end regions to the elongated test conductor. In addition, the location of the voltage tap at the point where the taper begins reduces the measurement error due to voltage drop in the end regions, while still avoiding excessive thermal effects due to the heating of the test conductor. Furthermore, the inventive test structure may be provided for any of the metal levels on the integrated circuit. In that case, the width of the test conductor may be different for the different levels, as may be desirable due to the differing minimum linewidths of the different levels. It may even be used to test interconnects; that is, a long row of contact windows that connect one metal level to another, in what is referred to in the art as a "stitch pattern". All such uses are included herein.

## Claims

1. A method of making an integrated circuit including the step of determining the electromigration characteristics of an integrated circuit conductor by steps comprising flowing an electrical current through a test structure, and determining the time for a failure to occur, said test structure comprising an elongated test conductor (101) at least 50 »m long, wherein said elongated test conductor is contacted at its ends by wider metal conductors (102, 103)
Characterized in that the current density of said electrical current is at least 5 X 10⁶amps/cm², and in that said wider metal conductors have a width (W₁) at least 5 times the width (W₂) of said elongated test conductor, and with said wider metal conductors tapering down to the width of said test conductor, with the taper angle (ϑ) being in the range of 30 to 60 degrees.

2. The method of claim 1 wherein the width (W₁) of the wider metal conductors (102, 103) is about 10 times the width (W₂) of said elongated test conductor (101).

3. The method of claim 1 wherein the taper angle (ϑ) is about 45 degrees.

4. The method of claim 1 wherein the current density of said electrical current is at least 1 X 10⁷A/cm².

5. The method of claim 1 wherein said test conductor is about 800 »m long.

6. The method of claim 1 wherein said test structure further comprises voltage tap conductors (111, 113) that connect to each of said wider metal conductors (102, 103) at the point (113) at which said wider metal conductors taper down to the width of said test conductor.

7. The method of claim 1 wherein said test structure further comprises elongated side conductors (106, 107) located on both sides of said test conductor (101) and contacted by a bondpad (109).

8. The method of claim 1 wherein said test structure further comprises elongated topographic features (115-119) located under, and oriented generally transverse to, said test conductor (101), wherein said elongated topographic features are formed of conductive material that is insulated from said test conductor.

9. The method of claim 1 further comprising the step of adjusting a parameter of a process step used in making said integrated circuit in response to information derived from said determining the electromigration characteristics of an integrated circuit conductor.

10. The method of claim 9 wherein said process step is a dielectric deposition process, or a conductor forming process step.

11. The method of claim 10 wherein said parameter is the thickness of said dielectric or the thickness, the width, or the composition of the conductor.

12. The method of claim 10 wherein said conductor forming process step is a conductor deposition step or a conductor etching step.

13. A method of making an integrated circuit including the step of determining the electromigration characteristics of an integrated circuit conductor, CHARACTERIZED BY steps comprising flowing electrical current through first and second test structures, and comparing the effect of the current flow on the structures, wherein said first test structure comprises elongated topographic features (115-119) located under, and oriented generally transverse to, said test structure, and said second test structure is located on a generally planar surface, and further CHARACTERIZED IN THAT each of said test structures comprise elongated test conductors (101) at least 50 »m long, wherein said elongated test conductors are contacted and their ends by wider metal conductors (102,103) having a width (W₁) at least 5 times the width (W₂) of said elongated test conductors, and with said wider metal conductors tapering down to the width of said test conductors, with the taper angle (ϑ) being in the range of 30 to 60 degrees.

14. The method of claim 13 wherein the current density of said electrical current is at least 5 X 10⁶A/cm².

15. The method of claim 13 wherein said elongated topographic features are formed of conductive material that is insulated from said test conductor.

16. The method of claim 13 wherein said comparing step includes comparing the resistance of the test conductor of said first test structure to the resistance of the test conductor of said second test structure during said flowing electrical current, or comparing the time of failure of the test conductor of said first test structure to the time of failure of the test conductor of said second test structure.

17. An integrated circuit including an electromigration test structure, said test structure comprising an elongated test conductor (101) at least 50 »m long and having a width (W₂) of less than 10 »m, wherein said elongated test conductor is contacted at its ends by wider metal conductors (102,103) which in turn are connected to bondpads (104,105), CHARACTERIZED IN THAT said wider metal conductors have a width (W₁) at least 5 times the width of said elongated test conductor, wherein said wider metal conductors taper down to the width of said test conductor, with the taper angle (ϑ) being in the range of 30 to 60 degrees.

18. The integrated circuit of claim 17 wherein the width (W₁) of said wider metal conductors (102, 103) is approximately 10 times the width (W₂) of said elongated test conductor (101).

19. The integrated circuit of claim 17 wherein said test structure further comprises voltage tap conductors (111,113) that connect to each of said wider metal conductors (102,103) at the point (120) at which said wider metal conductors taper down to the width of said test conductor.

20. The integrated circuit of claim 17 wherein said test structure further comprises elongated side conductors (106,107) located on both sides of said test conductor (101) and contacted by a bondpad (109).

21. The integrated circuit of claim 17 wherein said test structure further comprises elongated topographic features (115-119) located under, and oriented generally transverse to, said test conductor (101), wherein said elongated topographic features are formed of conductive material that is insulated from said test conductor.

## Patentansprüche

1. Verfahren zur Herstellung einer integrierten Schaltung, mit dem Schritt des Feststellens der Elektromigrationseigenschaften eines Leiters einer integrierten Schaltung mit den Schritten umfassend das Fließenlassen eines elektrischen Stroms durch eine Prüfungsstruktur und Feststellen der Zeit für das Auftreten eines Ausfalls, wobei die Prüfstruktur einen langgestreckten Prüfleiter (101), der wenigstens 50 »m lang ist, umfaßt, wobei der langgestreckte Prüfleiter an seinen Enden mit breiteren Metalleitern (102, 103) in Kontakt steht,
dadurch gekennzeichnet, daß die Stromdichte des elektrischen Stroms wenigstens 5 X 10⁶ A/cm² beträgt und daß die breiteren Metalleiter eine Breite (W₁) haben, die wenigstens 5 mal die Breite (W₂) des langgestreckten Prüfleiters beträgt, wobei sich die breiteren Metalleiter zur Breite des Prüfleiters verjüngen, wobei der Verjüngungswinkel (ϑ) im Bereich von 30 bis 60 Grad liegt.

2. Verfahren nach Anspruch 1, in welchem die Breite (W₁) der breiteren Metalleiter (102, 103) ungefähr 10 mal die Breite (W₂) des langgestreckten Prüfleiters (101) beträgt.

3. Verfahren nach Anspruch 1, in welchem der Verjüngungswinkel (ϑ) ungefähr 45 Grad beträgt.

4. Verfahren nach Anspruch 1, in welchem die Stromdichte des elektrischen Stroms wenigstens 1 X 10⁷ A/cm² beträgt.

5. Verfahren nach Anspruch 1, in welchem der Prüfleiter ungefähr 800 »m lang ist.

6. Verfahren nach Anspruch 1, in welchem die Prüfstruktur ferner Spannungsabgriffleiter (111, 113) umfaßt, die jeden der breiteren Metalleiter (102, 103) an dem Punkt (113) kontaktieren, an welchem die breiteren Metalleiter sich zur Breite des Prüfleiters verjüngen.

7. Verfahren nach Anspruch 1, in welchem die Prüfstruktur ferner langgestreckte Seitenleiter (106, 107) umfaßt, die an beiden Seiten des Prüfleiters (101) angeordnet sind und mit einer Anschlußfläche für das Bonden (109) in Kontakt stehen.

8. Verfahren nach Anspruch 1, in welchem die Prüfstruktur ferner langgestreckte topographische Strukturen (115-119) umfaßt, die unter dem Prüfleiter (101) angeordnet sind und sich generell quer zu dem Prüfleiter (101) erstrecken, wobei die langgestreckten topographischen Strukturen aus leitfähigem Material, das von dem Prüfleiter isoliert ist, ausgebildet sind.

9. Verfahren nach Anspruch 1, ferner umfassend den Schritt des Einstellens eines Parameters eines Verfahrensschrittes, der bei der Herstellung der integrierten Schaltung verwendet wird, in Antwort auf Information, die aus dem Feststellen der Elektromigrationseigenschaften eines integrierten Schaltungsleiters erhalten worden ist.

10. Verfahren nach Anspruch 9, in welchem der Verfahrensschritt ein dielektrischer Abscheidungs-Verfahrensschritt oder ein Leiterausbildungs-Verfahrensschritt ist.

11. Verfahren nach Anspruch 10, in welchem der Parameter die Dicke des Dielektrikums oder die Dicke, die Breite oder die Zusammensetzung des Leiters ist.

12. Verfahren nach Anspruch 10, in welchem der Leiterausbildungs-Verfahrensschritt ein Leiter-Abscheidungsschritt oder ein Leiter-Ätzschritt ist.

13. Verfahren zur Herstellung einer integrierten Schaltung, umfassend den Schritt des Feststellens der Elektromigrationseigenschaften eines integrierten Schaltungsleiters, gekennzeichnet durch die Schritte, umfassend
das Fließenlassen eines elektrischen Stroms durch eine erste und eine zweite Prüfstruktur und Vergleichen der Wirkung des Stromflusses auf die Strukturen, wobei die erste Prüfstruktur langgestreckte topographische Strukturen (115-119) umfaßt, die unter der Prüfstruktur angeordnet sind und generell quer zur Prüfstruktur orientiert sind, und wobei die zweite Prüfstruktur an einer generell ebenen Oberfläche angeordnet ist und ferner dadurch gekennzeichnet, daß jede der Prüfstrukturen langgestreckte Prüfleiter (101) umfaßt, die wenigstens 50 »m lang sind, wobei die langgestreckten Prüfleiter und ihre Enden durch breitere Metalleiter (102, 103) mit einer Breite (W₁) von wenigstens 5 mal der Breite (W₂) des langgestreckten Prüfleiters kontaktiert werden, und wobei die breiteren Metalleiter sich zur Breite des Prüfleiters verjüngen, wobei der Verjüngungswinkel (ϑ) im Bereich von 30 bis 60 Grad liegt.

14. Verfahren nach Anspruch 13, in welchem die Stromdichte des elektrischen Stroms wenigstens 5 X 10⁶ A/cm² beträgt.

15. Verfahren nach Anspruch 13, in welchem die langgestreckten topographischen Strukturen aus leitfähigem Material ausgebildet sind, das von dem Prüfleiter isoliert ist.

16. Verfahren nach Anspruch 13, in welchem der Schritt des Vergleichens das Vergleichen des Widerstandes des Prüfleiters der ersten Prüfstruktur mit dem Widerstand des Prüfleiters der zweiten Prüfstruktur während des Fließenlassens eines elektrischen Stroms umfaßt, oder das Vergleichen der Ausfallzeit des Prüfleiters der ersten Prüfstruktur mit der Zeit des Ausfalls des Prüfleiters der zweiten Prüfstruktur umfaßt.

17. Integrierte Schaltung, umfassend eine Elektromigrationsprüfstruktur, wobei die Prüfstruktur einen langgestreckten Prüfleiter (101) umfaßt, der wenigstens 50 »m lang ist und eine Breite (W₂) von weniger als 10 »m hat, wobei der langgestreckte Prüfleiter an seinen Enden mit breiteren Metalleitern (102, 103) in Kontakt steht, die wiederum mit Anschlußflächen für das Bonden (104, 105) in Kontakt stehen, dadurch gekennzeichnet, daß die breiteren Metalleiter eine Breite (W₁) von wenigstens 5 mal der Breite des langgestreckten Prüfleiters haben, wobei die breiteren Metalleiter sich zur Breite des Prüfleiters verjüngen, wobei der Verjüngungswinkel (ϑ) im Bereich von 30 bis 60 Grad liegt.

18. Integrierte Schaltung nach Anspruch 17, in welcher die Breite (W₁) der breiteren Metalleiter (102, 103) ungefähr 10 mal die Breite (W₂) des langgestreckten Prüfleiters (101) beträgt.

19. Integrierte Schaltung nach Anspruch 17, in welcher die Prüfstruktur ferner Spannungsabgriff-Leiter (111, 113) umfaßt, die zu jedem der breiteren Metalleiter (102, 103) an den Punkt (20) verbinden, an welchem die breiteren Metalleiter sich zur Breite des Prüfleiters verjüngen.

20. Integrierte Schaltung nach Anspruch 17, in welcher die Prüfstruktur ferner langgestreckte Seitenleiter (106, 107) umfaßt, die an beiden Seiten des Prüfleiters (101) angeordnet sind und mit einer Anschlußfläche für das Bonden (109) in Kontakt stehen.

21. Integrierte Schaltung nach Anspruch 17, in welcher die Prüfstruktur ferner langgestreckte topographische Strukturen (115-119) unter dem Prüfleiter (101) angeordnet und generell quer zu dem Prüfleiter (101) orientiert umfaßt, wobei die langgestreckten topographischen Strukturen aus leitendem Material gebildet sind, das von dem Prüfleiter isoliert ist.

## Revendications

1. Méthode de réalisation d'un circuit intégré comportant l'opération de détermination des caractéristiques d'électromigration d'un conducteur de circuit intégré par des opérations comprenant le passage d'un courant électrique à travers une structure d'essai, et la détermination du temps écoulé avant l'occurrence d'une défaillance,
ladite structure d'essai comprenant un conducteur d'essai allongé (101) d'au moins 50 »m de long, dans laquelle ledit conducteur d'essai allongé est contacté à ses extrémités par des conducteurs métalliques plus larges (102,103),
caractérisée en ce que la densité de courant dudit courant électrique est au moins 5 X 10⁶ ampères/cm², et en ce que lesdits conducteurs métalliques plus larges ont une largeur (W₁) au moins 5 fois la largeur (W₂) dudit conducteur d'essai allongé, lesdits conducteurs métalliques plus larges décroissant jusqu'à la largeur dudit conducteur d'essai, l'angle de décroissance (ϑ) étant dans la gamme de 30 à 60 degrés.

2. Méthode selon la revendication 1, dans laquelle la largeur (W₁) des conducteurs métalliques plus larges (102,103) est environ 10 fois la largeur (W₂) dudit conducteur d'essai allongé (101).

3. Méthode selon la revendication 1, dans laquelle l'angle de décroissance (ϑ) est environ 45 degrés.

4. Méthode selon la revendication 1, dans laquelle la densité de courant dudit courant électrique est d'au moins 1 X 10⁷ A/cm².

5. Méthode selon la revendication 1, dans laquelle ledit conducteur d'essai est environ de 800 »m de long.

6. Méthode selon la revendication 1, dans laquelle ladite structure d'essai comprend en outre des conducteurs à prise de tension (111,113) qui se connectent à chacun des conducteurs métalliques plus larges (102,103) au point (113) où lesdits conducteurs métalliques plus larges décroissent jusqu'à la largeur dudit conducteur d'essai.

7. Méthode selon la revendication 1, dans laquelle ladite structure d'essai comprend en outre des conducteurs latéraux allongés (106,107) situés des deux côtés dudit conducteur d'essai (101) et contactés par une plage de connexion (109).

8. Méthode selon la revendication 1, dans laquelle ladite structure d'essai comprend en outre des détails topographiques allongés (115-119) situés sous, et orientés de manière générale transversalement audit conducteur d'essai (101), dans laquelle lesdits détails topographiques allongés sont formés en un corps conducteur qui est isolé dudit conducteur d'essai.

9. Méthode selon la revendication 1, comprenant en outre l'opération de réglage d'un paramètre d'une opération de procédé utilisé pour réaliser ledit circuit intégré en réponse aux informations dérivées de ladite détermination des caractéristiques d'électromigration d'un conducteur de circuit intégré.

10. Méthode selon la revendication 9, dans laquelle ladite opération de procédé est un procédé de dépôt de diélectrique, ou une opération de procédé de formation de conducteur.

11. Méthode selon la revendication 10, dans laquelle ledit paramètre est l'épaisseur dudit diélectrique ou l'épaisseur, la largeur, ou la composition du conducteur.

12. Méthode selon la revendication 10, dans laquelle ladite opération de procédé de formation de conducteur est une opération de dépôt de conducteur, ou une opération d'attaque chimique de conducteur.

13. Méthode de réalisation d'un circuit intégré comportant l'opération de détermination des caractéristiques d'électromigration d'un conducteur de circuit intégré, CARACTERISEE PAR des opérations comprenant le passage d'un courant électrique à travers des première et seconde structures d'essai, et la comparaison de l'effet du passage de courant sur les structures, dans laquelle ladite première structure d'essai comprend des détails topographiques allongés (115-119) situés sous, et orientés de manière générale transversalement à ladite structure d'essai, et ladite seconde structure d'essai est située sur une surface généralement plane, et en outre CARACTERISEE EN CE QUE chacune desdites structures d'essai comprend des conducteurs d'essai allongés (101) d'au moins 50 »m de long, dans laquelle lesdits conducteurs d'essai allongés sont contactés à leurs extrémités par des conducteurs métalliques plus larges (102,103) ayant une largeur (W₁) d'au moins 5 fois la largeur (W₂) desdits conducteurs d'essais allongés, et lesdits conducteurs métalliques plus larges décroissant jusqu'à la largeur desdits conducteurs d'essai, l'angle de décroissance (ϑ) étant dans la gamme de 30 à 60 degrés.

14. Méthode selon la revendication 13, dans laquelle la densité de courant dudit courant électrique est d'au moins 5 X 10⁶A/cm².

15. Méthode selon la revendication 13, dans laquelle lesdits détails topographiques allongés sont formés en un corps conducteur qui est isolé dudit conducteur d'essai.

16. Méthode selon la revendication 13, dans laquelle ladite opération de comparaison comporte la comparaison de la résistance du conducteur d'essai de ladite première structure d'essai avec la résistance du conducteur d'essai de ladite seconde structure d'essai durant ledit passage de courant électrique, ou la comparaison du temps de défaillance du conducteur d'essai de ladite première structure d'essai avec le temps de défaillance du conducteur d'essai de ladite seconde structure d'essai.

17. Circuit intégré comportant une structure d'essai d'électromigration, CARACTERISE EN CE QUE ladite structure d'essai comprend un conducteur d'essai allongé (101) d'au moins 50 »m de long et ayant une largeur (W₂) inférieure à 10 »m, dans lequel ledit conducteur d'essai allongé est contacté à ses extrémités par des conducteurs métalliques plus larges (102,103), eux-mêmes connectés à des plages de connexion (104,105), CARACTERISE EN CE QUE lesdits conducteurs métalliques plus larges ayant une largeur (W₁) au moins 5 fois la largeur dudit conducteur d'essai allongé, dans lequel lesdits conducteurs métalliques plus larges décroissent jusqu'à la largeur dudit conducteur d'essai, l'angle de décroissance (ϑ) étant dans la gamme de 30 à 60 degrés.

18. Circuit intégré selon la revendication 17, dans lequel la largeur (W₁) desdits conducteurs métalliques plus larges (102,103) est environ 10 fois la largeur (W₂) dudit conducteur d'essai allongé (101).

19. Circuit intégré selon la revendication 17, dans lequel ladite structure d'essai comprend en outre des conducteurs à prise de tension (111,113) qui se connectent à chacun desdits conducteurs métalliques plus larges (102,103) au point (120) où lesdits conducteurs métalliques plus larges décroissent jusqu'à la largeur dudit conducteur d'essai.

20. Circuit intégré selon la revendication 17, dans lequel ladite structure d'essai comprend en outre des conducteurs latéraux allongés (106,107) situés des deux côtés dudit conducteur d'essai (101) et contactés par une plage de connexion (109).

21. Circuit intégré selon la revendication 17, dans lequel ladite structure d'essai comprend en outre des détails topographiques allongés (115-119) situés sous, et orientés de manière générale transversalement audit conducteur d'essai (101), dans lequel lesdits détails topographiques allongés sont formés en un corps conducteur qui est isolé dudit conducteur d'essai.
